# EUROPÄISCHE PATENTSCHRIFT

(11) **EP 2 248 203 B1**
(45) Veröffentlichungstag und Bekanntmachung des Hinweises auf die Patenterteilung: **15.05.2013**
(21) Anmeldenummer: 09717722.4
(22) Anmeldetag: 05.03.2009
(51) Int. Cl.: H01L 51/52

(54) **OPTOELEKTRONISCHES BAUELEMENT**
OPTOELECTRONIC COMPONENT
COMPOSANT OPTOÉLECTRONIQUE

(30) Priorität: 07.03.2008 DE 102008013031
(43) Veröffentlichungstag der Anmeldung: 10.11.2010
(73) Patentinhaber: OSRAM Opto Semiconductors GmbH, 93055 Regensburg (DE)
(72) Erfinder: POPP, Michael, 80538 München (DE)
(74) Vertreter: Epping - Hermann - Fischer
(86) Internationale Anmeldenummer: PCT/DE2009/000313
(87) Internationale Veröffentlichungsnummer: WO 2009/109183

(56) Entgegenhaltungen:
- EP-A- 1 460 884
- WO-A-01/56000
- WO-A-2005/078691
- US-A1- 2003 010 985
- US-A1- 2003 155 151
- US-A1- 2004 095 300

## Beschreibung

Die Erfindung betrifft ein optoelektronisches Bauelement mit einer funktionellen Schicht.

Diese Patentanmeldung beansprucht die Priorität der deutschen Patentanmeldung DE 10 2008 013 031.1, deren Offenbarungsgehalt hiermit durch Rückbezug aufgenommen wird.

Die Druckschrift WO 99/27554 beschreibt ein Halbleiterbauelement.

Die Effizienz und die Lebensdauer von optoelektronischen Bauelementen, wie zum Beispiel Leuchtdioden, Infrarotemittierenden Leuchtdioden, organischen Leuchtdioden (OLEDs), organischen Solarzellen oder organischen Fotodetektoren mit funktionellen Schichten kann durch das Auftreten eines Kurzschlusses stark herabgesetzt werden.

Eine Aufgabe zumindest einer Ausführungsform der Erfindung ist es, ein optoelektronisches Bauelement mit einer Stromzuführung zu den funktionellen Schichten bereitzustellen, die eine Kurzschlusssicherung beinhaltet.

Diese Aufgabe wird durch ein optoelektronisches Bauelement gemäß dem Anspruch 1 gelöst. Weitere Ausgestaltungen und Weiterbildungen des optoelektronischen Bauelements sind Gegenstand weiterer Ansprüche und gehen weiterhin aus der nachfolgenden Beschreibung und den Zeichnungen hervor. Der Offenbarungsgehalt der Patentansprüche wird hiermit explizit durch Rückbezug in die Beschreibung aufgenommen.

Gemäß der erfindungsgemäßen Ausführungsform umfasst ein optoelektronisches Bauelement mit einer Kurzschlusssicherung die Merkmale von Anspruch 1.

Dass eine erste Schicht "auf" oder "über" einer zweiten Schicht angeordnet oder aufgebracht ist, kann dabei hier und im Folgenden bedeuten, dass die erste Schicht unmittelbar im direkten mechanischen und/oder elektrischen Kontakt auf der zweiten Schicht angeordnet oder aufgebracht ist. Weiterhin kann es auch bedeuten, dass die erste Schicht mittelbar auf beziehungsweise über der zweiten Schicht angeordnet oder aufgebracht ist. Dabei können dann weitere Schichten zwischen der ersten und der zweiten Schicht angeordnet oder aufgebracht sein.

Die Bezeichnungen "elektromagnetische Strahlung", "Strahlung" oder "Licht" können hier und im Folgenden eine elektromagnetische Strahlung mit zumindest einer Wellenlänge beziehungsweise einer spektralen Komponente in einem infraroten bis ultravioletten Wellenlängenbereich bedeuten. Insbesondere kann dabei infrarote, sichtbare und/oder ultraviolette elektromagnetische Strahlung bezeichnet sein.

"Mehrzahl" kann hier und im Folgenden eine Anzahl, etwa von Verbindungen oder Segmenten, bezeichnen, die größer oder gleich zwei ist.

Das hier beschriebene optoelektronische Bauelement weist eine Kurzschlusssicherung auf und kann im Vergleich mit bekannten optoelektronischen Bauelementen mit einer Kurzschlusssicherung einen Ausfall des optoelektronischen Bauelements infolge eines Kurzschlusses weitgehend vermeiden.

Dabei kann ein Ausfall eines optoelektronischen Bauelements durch einen Kurzschluss dadurch weitgehend vermieden werden, dass zwischen der Stromzuführung und zumindest einer der Mehrzahl der Segmente der ersten Elektrodenschicht zumindest jeweils eine der elektrischen Verbindungen angeordnet ist. Jede einzelne elektrische Verbindung ist dabei als Schmelzsicherung ausgeführt, sodass sie im Falle eines Kurzschlusses durchschmelzen kann.

Jede der zumindest einen der Mehrzahl der elektrischen Verbindungen, die zwischen einem Segment der ersten Elektrodenschicht und der Stromzuführung angeordnet ist, mit dem Segment und der Stromzuführung elektrisch leitend verbunden. In einem Normalbetrieb des optoelektronischen Bauelements können durch die Stromzuführung, jede der Mehrzahl der elektrischen Verbindungen und durch die jeweils den elektrischen Verbindungen zugeordneten Segmente der ersten Elektrodenschicht Strompfade gebildet werden.

Der erste Querschnitt und der zweite Querschnitt bezeichnen dabei die jeweiligen Querschnittflächen der Stromzuführung und der Mehrzahl der elektrischen Verbindung senkrecht zu den Strompfaden im Normalbetrieb des optoelektronischen Bauelements.

In herkömmlichen optoelektronischen Bauelementen können Kurzschlüsse aufgrund undefinierter Partikelbelastungen oder so genannter "pin-holes", wie etwa Mikrokanälen, entstehen, die die Strahlungsemission des optoelektronischen Bauelementes verhindern beziehungsweise ihre Effizienz zumindest stark herabsetzen. Liegt in einem optoelektronischen Bauelement ein Kurzschluss zwischen zwei elektrisch leitenden Teilen, beispielsweise zwischen zwei Elektroden, vor, so wird ein Großteil der zugeführten elektrischen Leistung nahezu widerstandslos als Verlustleistung über den Kurzschluss abgeführt. Durch den stark herabgesetzten ohmschen Widerstand kann durch die Kurzschlussverbindung ein hoher Strom fließen, der meist ein Mehrfaches des Betriebsstromes beträgt bei gleichzeitig stark herabgesetzter Spannung.

Da die Wahrscheinlichkeit eines Kurzschlusses mit einer größeren Fläche des optoelektronischen Bauelementes stark ansteigt, kann das Auftreten von Kurzschlüssen in herkömmlichen Bauelementen den Übergang zu großflächigeren Bauelementen verhindern. Dadurch, dass die erste Elektrodenschicht eine Mehrzahl von voneinander getrennt angeordneten Segmenten aufweist, ist es möglich, das hier beschriebene optoelektronische Bauelement großflächig, beispielsweise als großflächige Beleuchtungseinrichtung wie etwa eine Leuchtkachel zu betreiben, wobei sich das Bauelement durch eine erhöhte Lebensdauer und eine verbesserte Effizienz auszeichnet.

Des Weiteren ermöglicht die segmentierte Anordnung der ersten Elektrodenschicht in Verbindung mit den schmelzbaren elektrischen Verbindungen eine lokale Beschränkung des Kurzschlusses auf das vom Kurzschluss jeweils betroffene Segment. Im Falle eines auftretenden Kurzschlusses zwischen einem Segment der ersten Elektrodenschicht und der zweiten Elektrodenschicht kann die zumindest eine elektrische Verbindung, die zwischen dem Segment und der Stromzuführung angeordnet ist, durch den kurzschlussbedingten hohen Strom abschmelzen. Durch das Abschmelzen der elektrischen Verbindung wird lediglich das defekte Segment der ersten Elektrodenschicht vom aktiven Stromkreis getrennt. Der Widerstand der elektrischen Verbindung zwischen dem entsprechenden Segment und der Stromzuführung wird unendlich groß, während Segmente mit zugeordneten intakten elektrischen Verbindungen weiterhin betriebsbereit bleiben. Zusätzlich kann somit das Wachsen von Defekten, wie beispielsweise nicht-emittierender Flächen, etwa so genannte "dark spots"oder "black spots", sowie der degradierende Einfluss von so genannten "pin-holes" über das vom Kurzschluss betroffene Segment hinaus verhindert werden.

Darüber hinaus weisen die schmelzbaren elektrischen Verbindungen des optoelektronischen Bauelementes einen gegenüber der Stromzuführung reduzierten Querschnitt auf. Der gegenüber der Stromzuführung verringerte Querschnitt begünstigt das Abschmelzen der elektrischen Verbindung zusätzlich.

Der zweite Querschnitt der Mehrzahl der elektrischen Verbindungen kann für alle der Mehrzahl der elektrischen Verbindungen gleich sein. Alternativ dazu kann der zweite Querschnitt von zumindest zweien der Mehrzahl der elektrischen Verbindungen oder auch von allen der Mehrzahl der elektrischen Verbindungen verschieden sein. Dabei ist jedoch der Querschnitt aller der Mehrzahl der elektrischen Verbindungen kleiner als der erste Querschnitt der Stromzuführung.

Weiterhin kann der zweite Querschnitt zumindest um einen Faktor 10 im Vergleich zum ersten Querschnitt reduziert sein. Das kann insbesondere bedeuten, dass der zweite Querschnitt jeder der Mehrzahl der elektrischen Verbindungen im Vergleich zur Stromzuführung zumindest um den Faktor 10 reduziert sein kann. Weiterhin kann der Querschnitt jeder der Mehrzahl der elektrischen Verbindungen bevorzugt zumindest um einen Faktor 100, weiter bevorzugt um zumindest einen Faktor 500 und besonders bevorzugt um zumindest einen Faktor 1000 reduziert werden. Je kleiner der zweite Querschnitt im Vergleich zum ersten Querschnitt ist, desto schneller kann eine elektrische Verbindung im Falle eines Kurzschlusses abschmelzen.

Weiterhin kann ein größerer zweiter Querschnitt einen kleineren elektrischen Widerstand einer elektrischen Verbindung zufolge haben. Je nach Ausführungsform der elektrischen Verbindungen kann daher der zweite Querschnitt um einen Faktor 10 bis 100 oder um einen Faktor 100 bis 500 oder um einen Faktor 500 bis 1000 kleiner als der erste Querschnitt sein, wobei die Grenzen jeweils eingeschlossen sind.

Vorteilhaft kann jede der elektrischen Verbindungen als Einschnürung ausgeführt sein oder zumindest eine Einschnürung aufweisen, wobei sich die Einschnürung dabei über die gesamte Ausdehnung der elektrischen Verbindung entlang eines Strompfades im Normalbetrieb oder nur über einen Teil der elektrischen Verbindung erstrecken kann. Durch die Ausführung der elektrischen Verbindung als Einschnürung oder mit einer Einschnürung kann das Abschmelzen der elektrischen Verbindung im Falle eines Kurzschlusses zusätzlich verstärkt werden, da durch den reduzierten zweiten Querschnitt im Bereich der Einschnürung eine vergleichsweise höhere Stromdichte als in der Stromzuführung und gegebenenfalls im übrigen Teil der elektrischen Verbindung vorliegt.

Dabei wird der erste Querschnitt der Stromzuführung durch die Anzahl der zu kontaktierenden elektrischen Verbindungen bemessen. Insbesondere wird der erste Querschnitt der Stromzuführung so bemessen, dass der Querschnitt zur Versorgung der ersten Elektrodenschicht über zumindest jeweils eine der elektrischen Verbindung ausreicht. Die Stromzuführung weist dabei einen bevorzugten ersten Querschnitt von 10 µm² bis 1000 µm², weiter bevorzugt von 25 µm² bis 750 µm² und besonders bevorzugt von 50 µm² bis 500 µm² auf, wobei die Grenzen jeweils eingeschlossen sind. Weiterhin können die Stromzuführung und die Mehrzahl der elektrischen Verbindungen einstückig ausgebildet sein. Dies kann bedeuten, dass die Stromzuführung und die Mehrzahl der elektrischen Verbindungen zusammenhängend und/oder einteilig ausgeführt sein können. Die einstückige Ausführung der Stromzuführung und der Mehrzahl der elektrischen Verbindungen kann das Aufbringen der Stromzuführung und der Mehrzahl der elektrischen Verbindungen in einem Prozessschritt ermöglichen.

Gemäß einer weiteren Ausführungsform können die Mehrzahl der elektrischen Verbindungen und die Stromzuführung aus verschiedenen Materialien ausgebildet sein.

Weiterhin können sich zur Ausgestaltung der Mehrzahl der elektrischen Verbindungen beispielsweise leitfähige Materialien anbieten, die ausgewählt sein können aus Ag, Cu, Zn, Sn oder aus einer Legierung oder aus einer Mischung dieser in veränderlichen prozentualen Verhältnissen.

Sind die Mehrzahl der elektrischen Verbindungen und die Stromzuführung aus verschiedenen Materialien ausgebildet, so kann dies bedeuten, dass die Mehrzahl der elektrischen Verbindungen und die Stromzuführung nicht einstückig, zusammenhängend oder einteilig ausgeführt sind. Diese Ausführung kann jedoch ermöglichen, dass die Mehrzahl der elektrischen Verbindungen ein Material enthält, was gegenüber der Stromzuführung einen geringeren Schmelzpunkt aufweist und somit das Abschmelzen der elektrischen Verbindung im Falle eines Kurzschlusses begünstigen kann.

Die Mehrzahl der elektrischen Verbindungen kann weiterhin einen Schmelzpunkt zwischen größer oder gleich 150°C und kleiner oder gleich 1100°C aufweisen. Bevorzugt können dabei leitfähige Materialien für die Mehrzahl der elektrischen Verbindungen ausgewählt werden, die einen Schmelzpunkt zwischen 800°C und 1500°C, zwischen 250°C und 800°C und besonders bevorzugt zwischen 100°C und 250°C aufweisen, wobei die Grenzen jeweils eingeschlossen sind. Dabei kann es von Vorteil sein, neben den bereits genannten Materialien für die Mehrzahl der elektrischen Verbindungen, die über einen vergleichsweise hohen Schmelzpunkt verfügen, auch Materialien, wie beispielsweise Indium oder Aluminium, einzusetzen, die einen vergleichsweise niedrigen Schmelzpunkt aufweisen. Der vergleichsweise niedrige Schmelzpunkt von Indium oder Aluminium kann das Abschmelzen der Mehrzahl der elektrischen Verbindungen im Falle eines Kurzschlusses erleichtern.

Gemäß einer weiteren Ausführungsform umfasst das optoelektronische Bauelement ein Substrat, auf dem die Mehrzahl der Segmente der ersten Elektrodenschicht, die funktionelle Schicht und die zweite Elektrodenschicht angeordnet sind. Dabei kann das Substrat transparent oder transluzent, flexibel oder unelastisch sein und beispielsweise ein Glas, Quarz, Silikon, Kunststoff, Keramik oder eine Leiterplatte oder eine Kombination daraus umfassen. Beispiele für Kunststoff-Materialien sind Polyestercarbonat, Polyethersulphonat, Polyethylennaphthalat, Polyethylenterephthalat und Polyimid.

Weiterhin kann das Substrat so ausgeformt sein, dass es zwei Hauptoberflächen und zwei Seitenflächen umfasst, wobei die Hauptoberflächen eine größere Ausdehnung als die Seitenflächen besitzen. Daher können sich die Hauptoberflächen besonders zur Anordnung von Segmenten und weiteren Schichten des optoelektronischen Bauelementes eignen.

In der erfindungsgemäßen Ausführungsform können die Stromzuführung, die Mehrzahl der elektrischen Verbindungen und die Mehrzahl der Segmente der ersten Elektrodenschicht auf einer, also derselben, Hauptoberfläche des Substrats angeordnet sein. Dies kann bedeuten, dass die Stromzuführung, die Mehrzahl der elektrischen Verbindungen und die Mehrzahl der Segmente der ersten Elektrodenschicht benachbart zueinander angeordnet sind. Eine benachbarte Anordnung der Stromzuführung, der Mehrzahl der elektrischen Verbindungen und der Mehrzahl der Segmente der ersten Elektrodenschicht kann hier und im Folgenden bedeuten, dass die Stromzuführung und die Mehrzahl der elektrischen Verbindungen und/oder die Mehrzahl der elektrischen Verbindungen und die Mehrzahl der Segmente der ersten Elektrodenschicht in direktem Kontakt zueinander angeordnet sein können, sodass die Stromzuführung, die Mehrzahl der elektrischen Verbindungen und die Mehrzahl der Segmente der ersten Elektrodenschicht jeweils unmittelbar aneinander angrenzen.

Weiterhin kann auch ein mittelbarer Kontakt bezeichnet sein, bei dem weitere Segmente und/oder Schichten zwischen der Stromzuführung und der Mehrzahl der elektrischen Verbindungen und/oder der Mehrzahl der elektrischen Verbindungen und der Mehrzahl der Segmente der ersten Elektrodenschicht angeordnet sind.

Gemäß einer weiteren nicht erfindungsgemäßen Ausführungsform können die Stromzuführung und die Mehrzahl der Segmente der ersten Elektrodenschicht auf verschiedenen Hauptoberflächen des Substrats angeordnet sein. Dies kann bedeuten, dass beispielsweise die Stromzuführung auf einer ersten Hauptoberfläche des Substrates und die Mehrzahl der Segmente der ersten Elektrodenschicht auf einer zweiten Hauptoberfläche des Substrats angeordnet sind. Zur elektrischen Kontaktierung der Mehrzahl der Segmente der ersten Elektrodenschicht durch zumindest jeweils eine der elektrischen Verbindungen kann es daher erforderlich sein, dass die Mehrzahl der elektrischen Verbindungen im Substrat ausgeformt sind und sich durch das Substrat hindurch erstrecken.

Dazu können im Substrat in einer bevorzugt regelmäßigen Anordnung beispielsweise eine Mehrzahl von Öffnungen ausgeformt sein, in der jeweils eine der Mehrzahl der elektrischen Verbindungen angeordnet sein kann. Diese Öffnungen können regelmäßig oder unregelmäßig ausgeformte Querschnitte aufweisen. In einer regelmäßigen Ausführung können die Öffnungen beispielsweise polygonale, kreisförmige oder elliptische Querschnitte aufweisen. Dabei können die Öffnungen gleich oder verschieden voneinander ausgestaltet sein und können weiterhin beispielsweise auch Querschnitte aufweisen, die von einer der genannten Formen in eine andere übergehen.

Das erfindungsgemäße optoelektronische Bauelement umfasst einen Hohlraum umfassen, der im Substrat benachbart zu zumindest einer der Mehrzahl der elektrischen Verbindungen angeordnet ist. Der Hohlraum ist geeignet, im Falle eines Kurzschlusses schmelzendes Material der zumindest einen der Mehrzahl der elektrischen Verbindungen aufzunehmen. Dazu kann der Hohlraum beispielsweise als Vertiefung im Substrat ausgeformt sein, über der die elektrische Verbindung angeordnet ist. Damit kann der Hohlraum als Reservoir für das schmelzende Material der zumindest einen der Mehrzahl der elektrischen Verbindungen dienen.

Weiterhin kann das Substrat eine Mehrzahl von Hohlräumen aufweisen, wobei jede der Mehrzahl der elektrischen Verbindungen über einem der Mehrzahl der Hohlräume angeordnet sein kann. Darüber hinaus kann das Substrat einen zusammenhängenden Hohlraum aufweisen, über dem zumindest zwei der Mehrzahl der elektrischen Verbindungen oder alle davon angeordnet sind.

Gemäß einer weiteren Ausführungsform kann das optoelektronische Bauelement eine Isolatorschicht auf zumindest einer der Mehrzahl der elektrischen Verbindungen umfassen. Dabei kann die zumindest eine der Mehrzahl der elektrischen Verbindungen derart ausgeführt sein, dass die zumindest eine der Mehrzahl der elektrischen Verbindungen im Falle eines Kurzschlusses schmilzt und, dass die Isolatorschicht geeignet ist, die jeweils eine der Mehrzahl der elektrischen Verbindungen zu isolieren. Dabei kann die Isolatorschicht als Dielektrikum mit einem schmelzbaren und/oder rieselfähigen Material, wie beispielsweise
- einem Fotolack,
- einem thermoplastischen Material, das beispielsweise ausgewählt sein kann aus Acrylnitril-Butadien-Styrol (ABS), Polyamide (PA), Polycarbonat (PC), Polyethylen (PE), Polypropylen (PP), Polystyrol (PS), Polyvinylchlorid (PVC) oder aus Celluloid-haltigen Kunststoffen,
- Polyimiden,
- Metall- und/oder Halbmetalloxiden,
- Metall- und/oder Halbmetallnitriden,
- Metall- und/oder Halbmetalloxinitriden, wie beispielsweise Siliziumoxid oder Siliziumnitrid
ausgeführt und damit geeignet sein, die jeweils eine der Mehrzahl der elektrischen Verbindungen zu isolieren.

Im Falle eines Kurzschlusses können daher zum einen die jeweils eine der elektrischen Verbindungen, sowie die Isolatorschicht, die die elektrische Verbindung umgibt, schmelzbar sein. Gemäß der erfindungsgemäßen Anordnung ist dabei der Hohlraum jeweils benachbart zu der jeweils einen elektrischen Verbindung angeordnet, sodass das schmelzende Material der elektrischen Verbindung im Hohlraum aufgefangen werden kann. Die auf der jeweils einen elektrischen Verbindung angeordnete Isolatorschicht kann infolge des Kurzschlusses ebenfalls schmelzbar oder rieselfähig sein, sodass sich das schmelzende oder rieselnde Isolatormaterial zunächst im Bereich der schmelzenden elektrischen Verbindung anordnen und anschließend ebenfalls durch den Hohlraum aufgefangen werden kann. Dabei kann eine Durchmischung des Materials der jeweils einen elektrischen Verbindung mit dem Isolatormaterial erfolgen. Bevorzugt wird aber das Isolatormaterial in einem mengenmäßigen Überschuss gegenüber der jeweils einen elektrischen Verbindung vorliegen, sodass es nach der Durchmischung der beiden Materialien zu einer vermehrten Absättigung des Materials der elektrischen Verbindung durch das nachfließende oder nachrieselnde Isolatormaterial in den Hohlraum kommen kann. Im Zuge der fortschreitenden Absättigung kann das Isolatormaterial das Material der jeweils einen elektrischen Verbindung überschichten, womit der isolierende Effekt der Isolatorschicht gegenüber der jeweils einen elektrischen Verbindung eintreten kann.

Weiterhin kann die funktionelle Schicht zumindest zwei Segmente umfassen, die getrennt voneinander angeordnet sind, wobei jeweils ein Segment der funktionellen Schicht auf zumindest einem der Mehrzahl der Segmente der ersten Elektrodenschicht angeordnet ist. Das kann beispielsweise bedeuten, dass die zumindest zwei Segmente der funktionellen Schicht auch separat elektrisch durch zumindest eins der Mehrzahl der Segmente der ersten Elektrodenschicht kontaktierbar sind.

Weiterhin kann das bedeuten, dass die voneinander getrennten Segmente der funktionellen Schicht zu gleichen Zeiten betreibbar sind. Dabei können zumindest zwei Segmente der funktionellen Schicht Licht von zumindest zwei verschiedenen Spektren emittieren, sodass sich durch die Überlagerung der Spektren weißes Licht ergibt.

Dabei kann die funktionelle Schicht beziehungsweise jedes Segment der funktionellen Schicht einen mehrschichtigen Stapel funktioneller Schichten mit zumindest einer Licht emittierenden Schicht umfassen.

Weiterhin kann die funktionelle Schicht beziehungsweise jedes Segment der funktionellen Schicht beispielsweise zumindest eine oder mehrere Schichten ausgewählt aus n- und p-leitenden Schichten, etwa Elektroneninjektionsschichten, Elektronentransportschichten, Löcherblockierschichten, Elektronenblockierschichten, Löchertransportschichten und Löcherinjektionsschichten, aufweisen.

Die Licht emittierende Schicht kann beispielsweise einen herkömmlichen pn-Übergang, eine Doppelheterostruktur, eine Einfach-Quantentopfstruktur (SQW-Struktur) oder eine Mehrfach-Quantentopfstruktur (MQW-Struktur), ein lumineszierendes oder fluoreszierendes Material umfassen, wobei die Elektrolumineszenz durch die Rekombination von Elektronen und Löchern in der Licht emittierenden Schicht erzeugt wird.

Die funktionelle Schicht kann organische und/oder anorganische Materialien aufweisen.

Ein organisches Material kann organische Polymere oder kleine organische Moleküle umfassen. Bevorzugt umfassen organische Polymere vollständig oder teilweise konjugierte Polymere.

Geeignete organische Polymermaterialien umfassen zumindest eines der folgenden Materialien in jeder möglichen Kombination: Poly(p-phenylenvinylen)(PPV), Poly(2-methoxy-5(2-ethyl)hexyloxyphenylenvinylen)(MEH-PPV), zumindest ein PPV-Derivat (zum Beispiel Dialkoxy oder Dialkyl-Derivate) Polyfluorene und/oder Copolymere aufweisend Polyfluorensegmente, PPVs und verwandte Copolymere, Poly(2,7-(9,9-di-N-octylfluoren)-(1,4-Phenylen-((4-secbutylphenyl)imino)-1,4-phenylen)(TFB), Poly(2,7-(9,9-di-N-octylfluoren)-(1,4-phenylen-((4-methylphenyl)imino)-1,4-phenylen-((4-methylphenyl)imino)-1,4-phenylen))(PFM), Poly(2,7-(9,9-di-N-octylfluoren)-(1,4-phenylen-((4-methoxyphenyl)imino)-1,4-phenylen))(PFMO), Poly(2,7-(9,9-di-N-octylfluoren)(F8), Poly(2,7(9,9-di-N-octylfluoren)-3,6-benzothiadiazol)(F8BT), oder Poly(9,9-dioctylfluoren).

Alternativ zu Polymeren können auch kleine organische Moleküle in der organischen Funktionsschicht verwendet werden. Beispiele solcher kleinen Moleküle sind beispielsweise: Aluminium-tris(8-hydroxychinolin) (Alq₃), Aluminium-1,3-bis(N,N-dimethylaminophenyl)-1,3,4-oxydazol (OXD-8), Aluminium-oxo-bis(2-methyl-8-chinolin), Aluminium-bis(2-methyl-8-hydroxychinolin), Beryllium-bis(hydroxybenzochinolin) (BEQ.Sub.2), Bis(diphenylvinyl)biphenylen (DPVBI) und Arylaminsubstituierte Distyrylarylene(DSA-Amine). Des Weiteren kann die funktionelle Schicht anorganische Materialien wie beispielsweise III/V-Verbindungshalbleiter wie auf Nitrid- und/oder Phosphid- Verbindungshalbleitern basierende Materialien enthalten.

"Auf Nitrid-Verbindungshalbleitern basierend" bedeutet im vorliegenden Zusammenhang, dass die funktionelle Schicht ein Nitrid-III/V-Verbindungshalbleitermaterial, vorzugsweise AlₙGaₘInₗ₋ₙ₋ₘN, umfasst, wobei 0 ≤ n ≤ 1, 0 ≤ m ≤ 1 und n+m ≤ 1. Dabei muss dieses Material nicht zwingend eine mathematisch exakte Zusammensetzung nach obiger Formel aufweisen. Vielmehr kann es einen oder mehrere Dotierstoffe sowie zusätzliche Bestandteile aufweisen, die die charakteristischen physikalischen Eigenschaften des AlₙGaₘIn₁₋ₙ₋ₘN-Materials im Wesentlichen nicht ändern. Der Einfachheit halber beinhaltet obige Formel jedoch nur die wesentlichen Bestandteile des Kristallgitters (Al, Ga, In, N), auch wenn diese teilweise durch geringe Mengen weiterer Stoffe ersetzt sein können.

"Auf Phosphid-Verbindungshalbleitern basierend" bedeutet im vorliegenden Zusammenhang, dass die funktionelle Schicht ein Phosphid-III/V-Verbindungshalbleitermaterial, vorzugsweise AlₙGaₘIn₁₋ₙ₋ₘP, umfasst, wobei 0 ≤ n ≤ 1, 0 ≤ m ≤ 1 und n+m ≤ 1.

Weiterhin kann die funktionelle Schicht zusätzlich oder alternativ auch ein Halbleitermaterial basierend auf AlGaAs oder einem II/VI-Verbindungshalbleitermaterial aufweisen. Gemäß einer weiteren Ausführungsform kann die funktionelle Schicht auch zusammenhängend über zumindest zwei der Mehrzahl der Segmente der ersten Elektrodenschicht angeordnet sein. Dies ermöglicht eine großflächige und daher kostengünstige Aufbringung der funktionellen Schicht.

Weiterhin können die zumindest zwei der Mehrzahl der Segmente der ersten Elektrodenschicht parallel zueinander verschaltet sein. Eine solche Parallelschaltung von zumindest zweien der Mehrzahl der Segmente der ersten Elektrodenschicht ermöglicht im Gegensatz zu einer Schaltung der Segmente der ersten Elektrodenschicht in Reihe das Hinzufügen weiterer einzelner Segmente beziehungsweise auch die Außerbetriebnahme, beispielsweise durch einen Kurzschluss, ohne die Funktionalität der weiteren Segmente der ersten Elektrodenschicht zu beeinflussen.

Gemäß einer weiteren Ausführungsform kann das optoelektronische Bauelement weiterhin eine Stromaufweitungsschicht umfassen, die zwischen zumindest einer der Mehrzahl der elektrischen Verbindungen und zumindest einem der Mehrzahl der Segmente der ersten Elektrodenschicht angeordnet ist. Eine solche Stromaufweitungsschicht kann beispielsweise im Anschluss an die elektrische Verbindung zu Stromaufweitung verbreitert sein und beispielsweise ein transparentes, leitfähiges Oxid (TCO) umfassen oder aus einem solchen bestehen.

Transparente leitende Oxide können Metalloxide, wie beispielsweise Zinkoxid, Zinnoxid, Cadmiumoxid, Titanoxid, Indiumoxid oder Indiumzinnoxid (ITO) umfassen. Neben binären Metallsauerstoffverbindungen, wie beispielsweise ZnO, SnO₂ oder In₂O₃ gehören auch ternäre Metallsauerstoffverbindungen, wie beispielsweise Zn₂SnO₄, CdSnO3, ZnSnO₃, MgIn₂O₄, GaInO₃, Zn₂In₂O₅ oder In₄Sn₃O₁₂ oder Mischungen unterschiedlicher transparenter leitender Oxide zu der Gruppe der TCOs. Weiterhin entsprechen die TCOs nicht zwingend einer stöchiometrischen Zusammensetzung und können auch p- oder n-dotiert sein.

Weiterhin kann die zweite Elektrodenschicht zumindest zwei Segmente aufweisen und jeweils eins der zumindest zwei Segmente kann über zumindest einem der Mehrzahl der Segmente der ersten Elektrodenschicht angeordnet sein. Dies kann bedeuten, dass die zweite Elektrodenschicht mit einem der zumindest zwei Segmente über zumindest zwei Segmenten der ersten Elektrodenschicht angeordnet ist.

Alternativ ist es gemäß einer weiteren Ausführungsform auch möglich, die zweite Elektrodenschicht zusammenhängend über zumindest zweien der Mehrzahl der Segmente der ersten Elektrodenschicht anzuordnen. Dies kann bedeuten, dass die zweite Elektrodenschicht auch vorteilhaft großflächig über einer Mehrzahl der Segmente der ersten Elektrodenschicht aufgebracht sein kann.

Dabei kann das optoelektronische Bauelement als Licht emittierendes Bauelement, etwa als Leuchtdiode, Infrarotemittierende Leuchtdiode, organische Leuchtdiode (OLED), organische Solarzelle oder organischer Fotodetektor, mit einer Licht emittierenden funktionellen Schicht in Form eines so genannten Top- und/oder eines so genannten Bottom-Emitters ausgeführt sein.

In der Top-Emitter-Konfiguration kann vorteilhafterweise die zweite Elektrodenschicht eine Transparenz oder zumindest eine Transluzenz für zumindest einen Teil der elektromagnetischen Strahlung aufweisen.

Des Weiteren kann die zweite Elektrodenschicht in einer Top-Emitter-Konfiguration eine Licht streuende Schicht oder eine Streufolie aufweisen, die zum Beispiel als Polymerfolie ausgeführt sein kann. Weiterhin können der Streufolie oder der Licht streuenden Schicht Streupartikel zugemischt sein. Insbesondere können die Streupartikel beispielsweise ein Metalloxid, so etwa Titanoxid oder Aluminiumoxid, wie etwa Korund und/oder Glaspartikel umfassen. Die Streupartikel können dabei Durchmesser oder Korngrößen von weniger als 1 µm bis zu einer Größenordnung von 10 µm oder auch bis zu 100 µm aufweisen.

Alternativ und/oder zusätzlich kann die Licht streuende Schicht oder die Streufolie in einer Bottom-Emitter-Konfiguration auch auf ein transparentes Substrat aufgebracht werden.

In der Bottom-Emitter-Konfiguration kann vorteilhafterweise die erste Elektrodenschicht eine Transparenz oder zumindest eine Transluszenz für zumindest einen Teil der elektromagnetischen Strahlung aufweisen.

Eine transparente erste Elektrodenschicht, die als Anode ausgeführt sein kann und somit als Löcher-injizierendes Material mit einer Austrittsarbeit größer als 4.5 eV dient, kann beispielsweise ein wie zuvor bereits beschrieben transparentes leitendes Oxid aufweisen oder aus einem transparenten leitenden Oxid bestehen. Alternativ und/oder zusätzlich sind auch andere Anodenmaterialien denkbar wie beispielsweise
- Metalle wie Platin, Gold, Palladium oder Indium,
- Metalloxide wie Bleioxid, Zinnoxid oder Indiumzinnoxid (ITO),
- Graphit,
- dotierte anorganische Halbleiter wie Silizium, Germanium oder Galliumarsenid und
- dotierte leitfähige Polymere wie Polyanilline, Polypyrole oder Polythiophene).

In einer alternativen Konfiguration kann die erste Elektrodenschicht auch als Kathode ausgeführt sein.

Eine transparente zweite Elektrodenschicht, die als Kathode ausgeführt sein kann und somit als Elektroneninjektionsschicht mit einer vergleichsweise geringen Austrittsarbeit dient, kann beispielsweise als mehrschichtige Struktur ausgeformt sein, umfassend eine Ladungsinjektionsschicht und einer leitfähige Schicht. Die Ladungsinjektionsschicht kann Calcium oder Barium oder Mischungen dieser enthalten, während die leitfähige Schicht Aluminium, Silber, Magnesium, Gold, Kupfer oder eine Mischung dieser enthalten kann. In einer alternativen Konfiguration kann die zweite Elektrodenschicht auch als Anode ausgeführt sein.

Weitere Vorteile, bevorzugte Ausführungsformen und Weiterbildungen des optoelektronischen Bauelementes ergeben sich aus den im Folgenden und in Verbindung mit den Figuren erläuterten Ausführungsbeispielen.

Es zeigen:
- Figuren 1A und 1B: schematische Darstellungen eines optoelektronischen Bauelements in einer Aufsicht (Figur 1A) und in einer Schnittdarstellung (Figur 1B),
- Figur 2: schematische Schnittdarstellung eines optoelektronischen Bauelements,
- Figur 3: schematische Schnittdarstellungen eines optoelektronischen Bauelements gemäß des erfindungsgemäßen Ausführungsbeispiel,
- Figuren 4A und 4B: schematische Darstellungen eines optoelektronischen Bauelements gemäß einem weiteren Ausführungsbeispiel in einer Aufsicht (Figur 4A) und in einer Schnittdarstellung (Figur 4B),
- Figur 5: schematische Darstellung eines optoelektronischen Bauelements gemäß einem weiteren Ausführungsbeispiel.
- Figuren 6 und 7: schematische Darstellungen von optoelektronischen Bauelementen gemäß weiteren Ausführungsbeispielen.

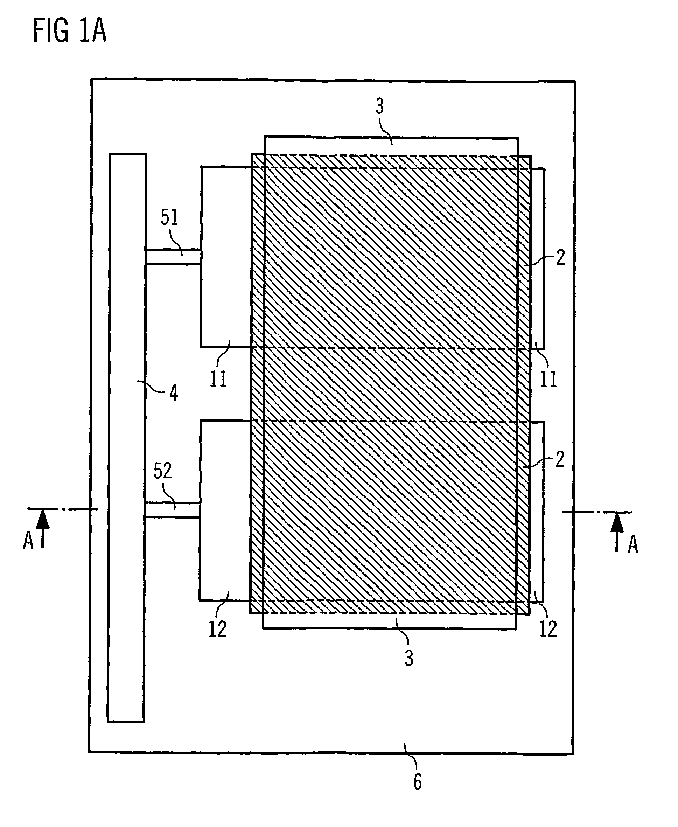

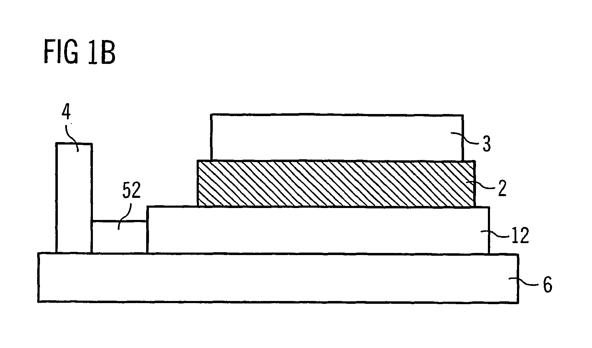

Figur 1A zeigt eine schematische Darstellung eines optoelektronischen Bauelementes in einer Aufsicht. Figur 1B zeigt eine schematische Schnittdarstellung des optoelektronischen Bauelements in der in Figur 1A markierten Schnittebene AA. Dabei zeigen die Figuren 1A und 1B sowie alle weiteren Figuren das optoelektronische Bauelement in einer Ausführung mit einer organischen funktionellen Schicht. Die in den Figuren 1A bis 7 beschriebene Ausführung des optoelektronischen Bauelementes ist jedoch auch mit einer oder mehreren funktionellen Schichten möglich, die zusätzlich oder alternativ anorganische Materialien, wie beispielsweise III/V-Verbindungshalbleiter, enthalten.

Gemäß der Figur 1A weist ein optoelektronische Bauelement ein Substrat 6 mit einer ersten Elektrodenschicht 1 mit zwei Segmenten 11, 12 auf, die getrennt voneinander auf einer Hauptoberfläche des Substrats 6 angeordnet sind. Auf dem jeweiligen Segment 11, 12 der ersten Elektrodenschicht 1 ist eine organische funktionelle Schicht 2 angeordnet, die im Betrieb elektromagnetische Strahlung emittiert. Weiterhin ist auf der organischen funktionellen Schicht 2 eine zweite Elektrodenschicht 3 angeordnet. Die organische funktionelle Schicht 2 und die zweite Elektrodenschicht 3 sind jeweils zusammenhängend über beiden Segmenten 11, 12 der ersten Elektrodenschicht 1 angeordnet, wobei die Segmente 11, 12 und die Schichten 2, 3 zur Verdeutlichung der Anordnung in der Figur 1A nicht überlappend dargestellt sind.

Dabei sind die beiden Segmente 11, 12 der ersten Elektrodenschicht 1 parallel zueinander verschaltet und jedes der Segmente 11, 12 der ersten Elektrodenschicht 1 ist durch jeweils eine elektrische Verbindung 51, 52 mit einer Stromzuführung 4 verbunden. Weiterhin kann das Segment 11 und/oder das Segment 12 alternativ zum gezeigten Ausführungsbeispiel durch mehr als eine elektrische Verbindung 51 beziehungsweise 52 mit der Stromzuführung 4 elektrisch leitend verbunden sein.

Die Stromzuführung 4 weist einen ersten Querschnitt auf. Weiterhin sind die elektrischen Verbindungen 51, 52 jeweils als Schmelzsicherungen ausgeführt und weisen jeweils einen zweiten Querschnitt auf, der gegenüber dem ersten Querschnitt der Stromzuführung 4 reduziert ist. Liegt beispielsweise zwischen dem Segment 11 der ersten Elektrodenschicht 1 und der zweiten Elektrodenschicht 3 ein Kurzschluss vor, so kann die das Segment 11 kontaktierende elektrische Verbindung 51 abschmelzen. Das Abschmelzen der elektrischen Verbindung 51 wird durch den reduzierten zweiten Querschnitt der elektrischen Verbindungen 51 begünstigt.

Die elektrischen Verbindungen 51, 52 und die Stromzuführung 4 können zum einen einstückig ausgebildet sein oder alternativ, wie in der Figur 1B dargestellt, aus zwei benachbart angeordneten elektrisch leitfähigen Elementen ausgebildet sein. Sind die Stromzuführung 4 und die elektrischen Verbindungen 51, 52 nicht einstückig ausgebildet, so bietet es sich an, die elektrischen Verbindungen 51, 52 und die Stromzuführung 4 aus verschiedenen Materialien auszuformen.

Dabei können für die elektrische Verbindungen 51, 52 Materialien wie im allgemeinen Teil beschrieben, ausgewählt werden, die einen Schmelzpunkt zwischen größer oder gleich 150°C und kleiner oder gleich 1100°C aufweisen. Dabei werden zur Ausformung der elektrischen Verbindungen 51, 52 Materialien wie beispielsweise Indium oder Aluminium bevorzugt, die gegenüber den weiteren, im allgemeinen Teil beschriebenen Materialien einen geringeren Schmelzpunkt aufweisen, um das Abschmelzen der elektrischen Verbindungen 51, 52 im Falle eines Kurzschlusses zu erleichtern.

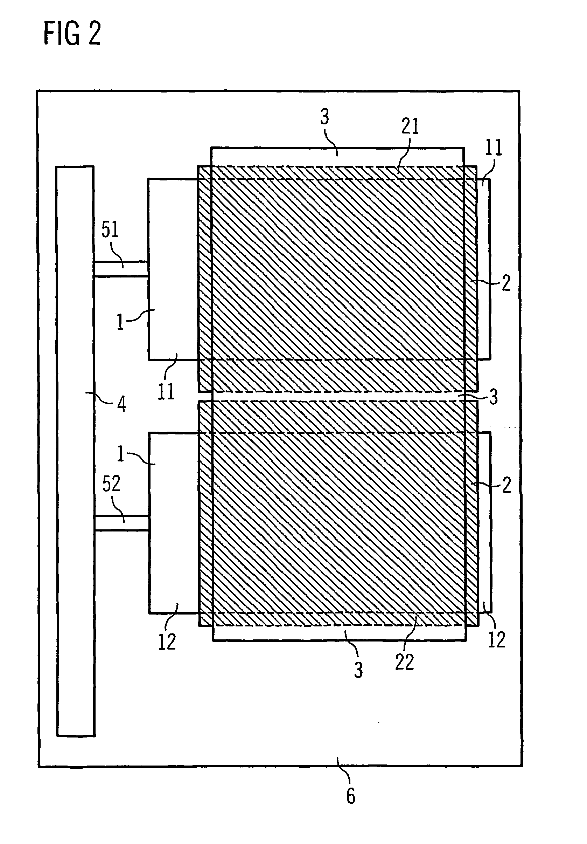

Figur 2 zeigt in einer schematischen Schnittdarstellung ein optoelektronisches Bauelement mit einer organischen funktionellen Schicht 2, die zwei Segmente 21, 22 umfasst. Dabei sind die zwei Segmente 21, 22 der organischen funktionellen Schicht 2 voneinander getrennt angeordnet, wobei jeweils ein Segment 21, 22 der organischen funktionellen Schicht 2 auf jeweils einem Segment 11, 12 der ersten Elektrodenschicht 1 angeordnet ist.

Die zweite Elektrodenschicht 3 ist wie in der Figur 2 dargestellt, zusammenhängend über zwei Segmenten 11, 12 der ersten Elektrodenschicht 1 angeordnet. Alternativ kann die zweite Elektrodenschicht 3 ebenfalls zumindest zwei Segmente 31, 32 aufweisen, wobei jeweils eines der Segmente der zweiten Elektrodenschicht 3 auf jeweils einem Segment 11, 12 der ersten Elektrodenschicht 1 angeordnet ist.

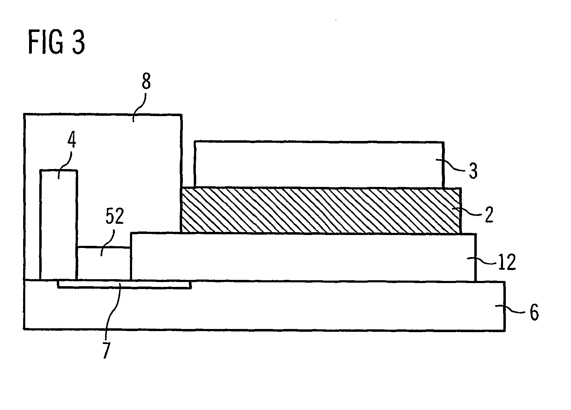

Figur 3 zeigt in einer schematischen Schnittdarstellung erfindungsgemäßen ein optoelektronisches Bauelement. . Dabei kann das optoelektronische Bauelement wie die der Figuren 1A oder 2 ausgeführt sein.

Das Substrat 6 des hier gezeigten optoelektronischen Bauelements weist einen Hohlraum 7 auf, über dem eine elektrische Verbindung 52 einer Mehrzahl von elektrischen Verbindungen angeordnet ist. Weiterhin weist das optoelektronische Bauelement eine Isolatorschicht 8 auf, die auf der elektrischen Verbindung 52 aufgebracht ist. Dabei ist der Hohlraum 7 als Vertiefung im Substrat 6 benachbart zu der elektrischen Verbindungen 52 angeordnet.

Der Hohlraum kann zusammenhängend als Reservoir für das schmelzende Material aller der Mehrzahl der elektrischen Verbindungen 5 im Substrat ausgeformt sein. Alternativ kann auch für jede der elektrischen Verbindungen 5 jeweils ein Hohlraum 7 benachbart zur jeweiligen elektrischen Verbindung 5 im Substrat 6 ausgeformt werden.

Der Hohlraum 7 wird als Merkmal allein oder mit der Isolatorschicht 8 in einem optoelektronischen Bauelement verwendet.

Zusätzlich umgibt die Isolatorschicht 8 auch die Stromzuführung 4. Liegt an einem derartig ausgestalteten optoelektronischen Bauelement ein Kurzschluss zwischen dem Segment 12 der ersten Elektrodenschicht 1 und der zweiten Elektrodenschicht 3 vor, so kann das schmelzende Material der elektrischen Verbindung 52 von dem Hohlraum 7, der bevorzugt als Reservoir ausgeformt ist, aufgefangen werden. In den frei werdenden Raum der elektrischen Verbindung 52 kann nun ebenfalls schmelzendes Material der Isolatorschicht 8 vordringen. In dem Hohlraum 7 kann es zunächst zu einer Vermischung des Materials der elektrischen Verbindung 52 und des Isolatormaterials 8 kommen.

Infolge des mengenmäßig überwiegenden Anteils des Isolatormaterials gegenüber dem Material der elektrischen Verbindung 52 kann eine Sättigung des Materials der elektrischen Verbindung 52 durch das nachfließende Material der Isolatorschicht 8 erfolgen. Infolge der Absättigung des Materials der elektrischen Verbindung 52 durch das Isolatormaterial 8 kann eine Überschichtung des Materials der elektrischen Verbindung 52 durch das Isolatormaterial 8 erfolgen, was den zu erzielenden isolierenden Effekt der Isolatorschicht 8 gegenüber der elektrischen Verbindung 52 darstellt.

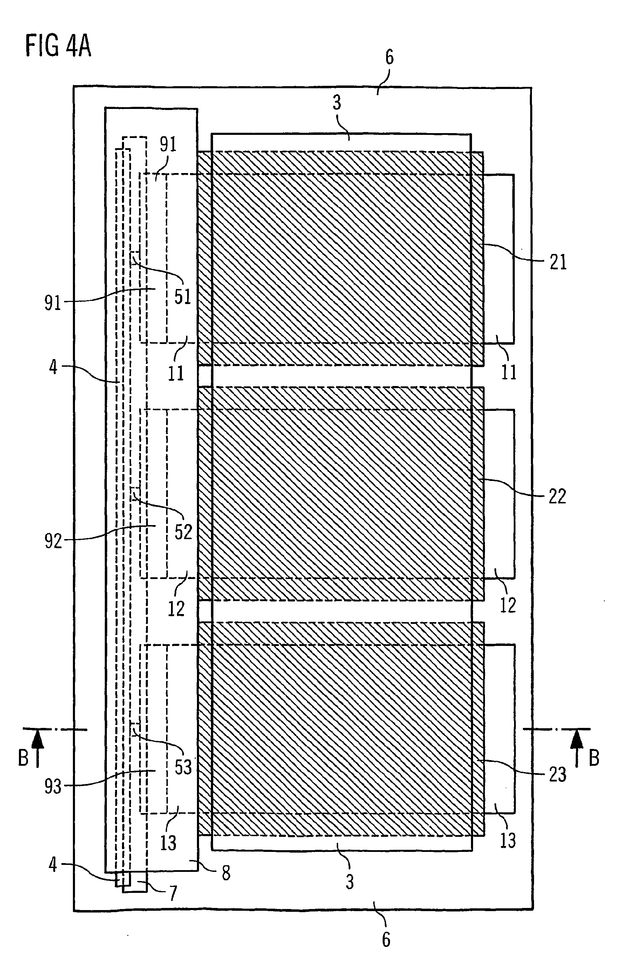

Figur 4A zeigt in einer schematischen Darstellung ein optoelektronisches Bauelement gemäß einem weiteren Ausführungsbeispiel in einer Aufsicht.

Das optoelektronische Bauelement weiter weist einen Hohlraum 7 auf, der als Vertiefung im Substrat 6 benachbart zu den elektrischen Verbindungen 51, 52, 53 angeordnet und zusammenhängend als Reservoir für das schmelzende Material aller der Mehrzahl der elektrischen Verbindungen 51, 52, 53 im Substrat ausgeformt ist. Alternativ kann auch für jede der elektrischen Verbindungen 51, 52, 53 jeweils ein Hohlraum 7 benachbart zur jeweiligen elektrischen Verbindung 51, 52, 53 im Substrat 6 ausgeformt werden. Das optoelektronische Bauelement weiter weist dabei eine Stromaufweitungsschicht 91, 92, 93 auf, die zwischen jeweils einer elektrischen Verbindung 51, 52, 53 und jeweils einem Segment der ersten Elektrodenschicht 11, 12, 13 angeordnet ist und ebenfalls durch die Isolatorschicht 8 umgeben wird. Die Stromaufweitungsschicht 91, 92, 93 kann zur Stromaufweitung auch verbreitert sein, um die Stromversorgung der Segmente der ersten Elektrodenschicht 11, 12, 13 zu verbessern.

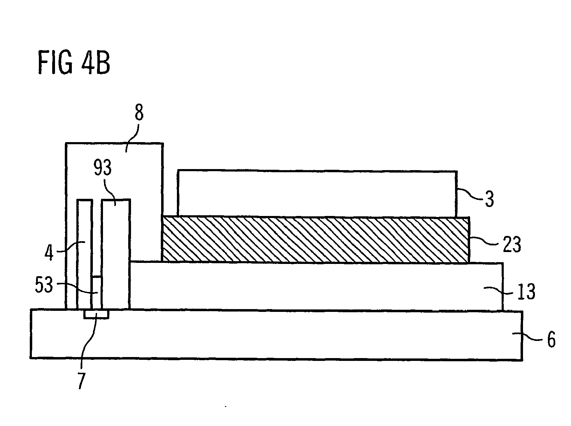

Figur 4B zeigt eine schematische Schnittdarstellung des optoelektronischen Bauelements aus Figur 4A in der in Figur 4A markierten Schnittebene BB.

Die Stromaufweitungsschicht 93 ist zwischen der ersten Elektrodenschicht 13 und der elektrischen Verbindung 53 angeordnet. Wie in Figur 4B dargestellt, kann sich der Hohlraum 7 im Substrat 6 auch über den Bereich der elektrischen Verbindung 53 hinaus erstrecken. Dabei ist die horizontale, aber auch die vertikale Ausdehnung des Hohlraums 7 im Substrat 6 abhängig von der Menge des aufzunehmenden schmelzenden Materials der elektrischen Verbindung 5 und der Isolatorschicht 8.

Des Weiteren kann, wie in Figur 4A dargestellt, ein zusammenhängender Hohlraum 7 als Reservoir für das schmelzbare Material aller der Mehrzahl der elektrischen Verbindungen 51, 52, 53 im Substrat 6 ausgeformt sein. Alternativ kann auch für jede der elektrischen Verbindungen 51, 52, 53 jeweils ein Hohlraum 7 benachbart zur jeweiligen elektrischen Verbindung 51, 52, 53 im Substrat 6 ausgeformt werden.

Der Hohlraum 7 wird als Merkmale allein oder mit der Isolatorschicht 8 oder mit der Stromaufweitungsschicht 9 oder mit der Isolatorschicht 8 und der Stromaufweiterungsschicht 9 zusammen in jeweils einem optoelektronischen Bauelement verwendet.

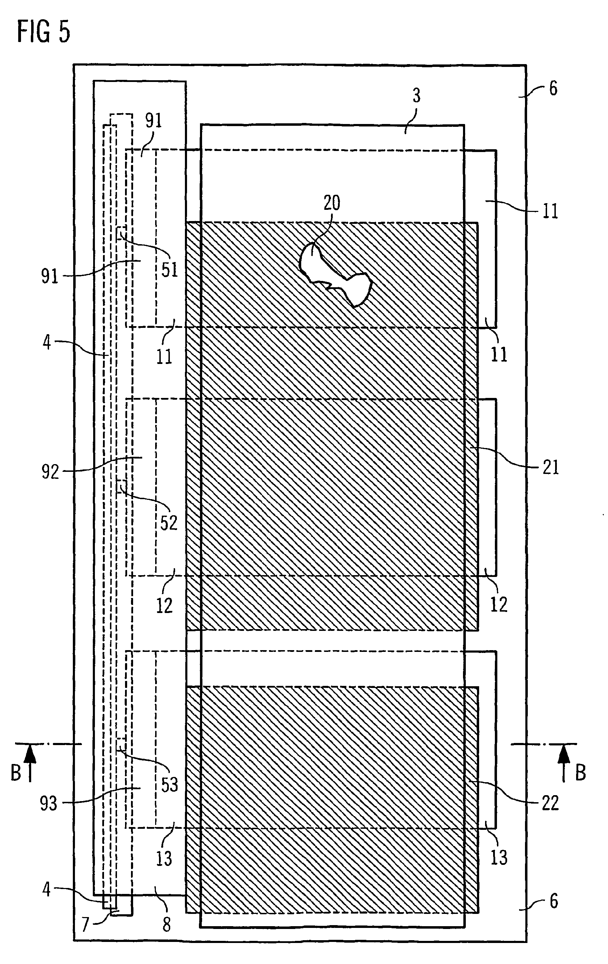

Figur 5 zeigt eine schematische Darstellung eines optoelektronischen Bauelementes in Aufsicht. Hier wird die Anordnung von zwei Segmenten 21, 22 der organischen funktionellen Schicht 2 über drei Segmente 11, 12, 13 der ersten Elektrodenschicht 1 gezeigt, beide Segmente 21, 22 der organischen funktionellen Schicht 2 sind aufgrund der typischen Ungenauigkeit der momentan verfügbaren Schattenmaskierungstechnik verschoben angeordnet.

Im herkömmlichen Verfahren zur strukturierten Aufbringung von organischen funktionellen Schichten mittels der Schattenmaskierungstechnik werden die Segmente 21, 22 der organischen funktionellen Schicht 2 aus Sicherheitsgründen mit einem Abstand von mindestens 200 µm zueinander aufgebracht. Dies entspricht der größten Ungenauigkeit der momentanen Maskierungstechnik, wodurch die Leuchtfläche auf unter 80% der Gesamtfläche sinkt. Durch die Segmente 11, 12, 13 der ersten Elektrodenschicht 1 und die Anordnung der Mehrzahl von elektrischen Verbindungen 51, 52, 53 kann der Abstand kleiner gewählt werden und damit eine größere Leuchtfläche erreicht werden, wodurch derartige Produktionsfehler ausgeglichen werden können.

Zudem weist das Segment 21 der organischen funktionellen Schicht 2 rein beispielhaft im Bereich des Segmentes 11 der ersten Elektrodenschicht 1 einen Defekt 20 auf, der aufgrund eines Kurzschlusses zum Abschmelzen der elektrischen Verbindung 51 und zur Isolierung des defekten Segmentes 11 vom übrigen Stromkreis führt. Die weitere Stromversorgung des Segments 21 ist weiterhin durch die elektrische Verbindung 52 und durch das Segment 12 der ersten Elektrodenschicht 1 gewährleistet, wobei aufgrund der geringen Querleitfähigkeit der organischen funktionellen Schicht 21 nahezu kein Stromfluss durch den Defekt 20 mehr auftreten kann. Obwohl die Emission elektromagnetischer Strahlung durch das Segment 21 reduziert ist, kann ein Totalausfall des optoelektronischen Bauelements im Falle eines derartigen Kurzschlusses durch die Mehrzahl von elektrischen Verbindungen 51, 52, 53 wirkungsvoll verhindert werden.

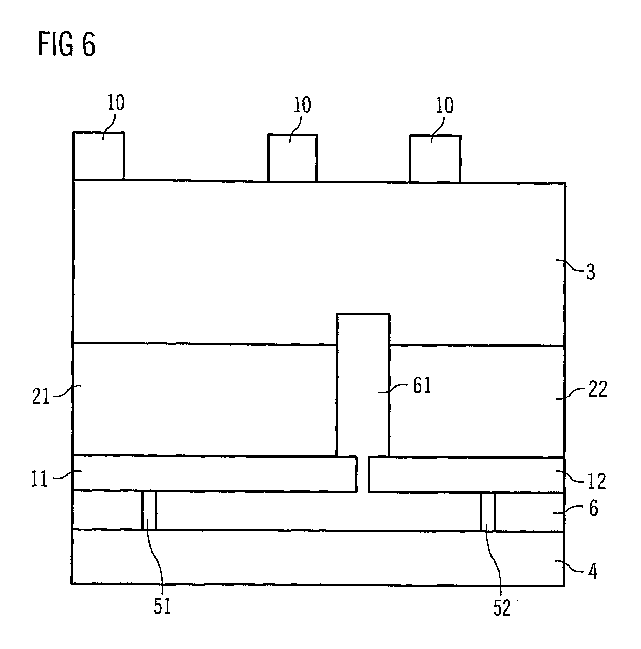

Figur 6 zeigt eine schematische Schnittdarstellung eines nicht erfindungsgemäßen optoelektronischen Bauelements.

Dabei ist eine Stromzuführung 4 auf einer Hauptoberfläche eines Substrats 6 angeordnet. Alternativ kann auch die Stromzuführung 4 als nicht-transparentes, also opakes, leitfähiges Substrat ausgeformt sein. Über der Stromzuführung 4 sind elektrische Verbindungen 51, 52 angeordnet. Die auf der Stromzuführung 4 angeordneten elektrischen Verbindungen 51, 52 sind in Öffnungen 511, 512 des Substrats 6, die als Durchstoßlöcher (Vias) ausgebildet sind, ausgeformt und kontaktieren jeweils eins der Segmente 11, 12 der ersten Elektrodenschicht 1. Die Segmente 11, 12 der ersten Elektrodenschicht 1 sind auf einer ersten Hauptfläche des Substrat 6 angeordnet, während die Stromzuführung 4 auf einer zweiten Hauptfläche des Substrates 6 angeordnet ist, wobei die erste und die zweite Hauptoberfläche des Substrates 6 verschieden voneinander und voneinander weggewandt sind. Die elektrischen Verbindungen 51, 52 können im Fall, dass die Stromzuführung 4 als Substrat ausgeformt ist, alternativ statt im Substrat 6 auch in einer Isolatorschicht 8 ausgeformt sein.

Die elektrischen Verbindungen 51, 52 können des Weiteren aus einem leicht schmelzenden, leitfähigen Material ausgebildet sein und sind im Falle einer hohen thermischen Belastung, wie beispielsweise einem Kurzschluss schmelzbar. Die elektrischen Verbindungen 51, 52 können durch einen Standardlithografieprozess aufgebracht werden.

Auf die elektrischen Verbindungen 51, 52 werden die Segmente 11, 12 der ersten Elektrodenschicht 1 strukturiert beispielsweise durch Soft-Sputtern oder Aufdampfen aufgebracht. Zusätzlich kann zwischen den elektrischen Verbindungen 51, 52 und den Segmenten 11, 12 der ersten Elektrodenschicht 1 eine Stromaufweitungsschicht aufgebracht sein.

Auf die erste Elektrodenschicht 1 ist eine organische funktionelle Schicht 2 aufgebracht. Wie in Figur 6 dargestellt, sind die erste Elektrodenschicht 1 und die organische funktionelle Schicht 2 in Segmenten 11, 12, beziehungsweise 21, 22 angeordnet. Die Segmentierung der ersten Elektrodenschicht 1, der organischen funktionellen Schicht 2, sowie der Stromaufweitungsschicht 9 wird durch einen Fortsatz 61 des Substrates 6 erzielt, der sich durch die erste Elektrodenschicht 1 und die organische funktionelle Schicht 2 hindurch erstreckt.

Auf der organischen funktionellen Schicht 2 ist weiterhin eine zweite Elektrode 3 aufgebracht, die zur Lichtemission in einer Top-Emitter-Konfiguration vorteilhaft aus einem transparenten Material ausgeformt ist. Auf der zweiten Elektrodenschicht 3 sind zusätzlich obere Kontakte 10 zur Stromleitung strukturiert angeordnet, die beispielsweise als Kontakte für einen Bonddraht dienen können.

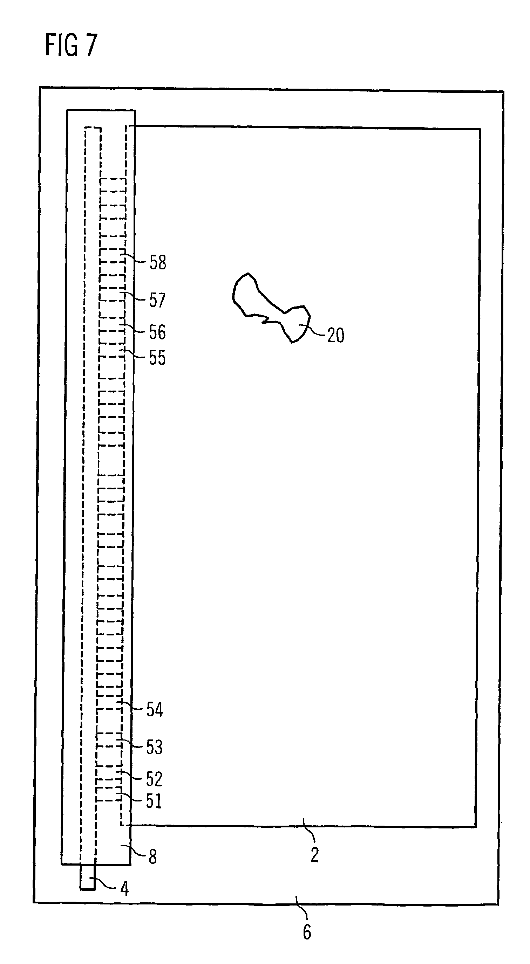

Figur 7 zeigt eine schematische Darstellung eines weiteren nicht erfindungsgemäßen optoelektronischen Bauelementes in Aufsicht mit einer ganzflächig aufgebrachten organischen funktionellen Schicht 2, die auf einer Mehrzahl von Segmenten der ersten Elektrodenschicht 1 (nicht gezeigt) angeordnet ist.

Die Mehrzahl der Segmente der erste Elektrodenschicht 1 wird dabei von einer Mehrzahl elektrischer Verbindungen kontaktiert, wobei beispielhaft elektrischen Verbindungen 51, 52, 53, 54, 55, 56, 57, 58 gekennzeichnet sind. Dabei ist im gezeigten Ausführungsbeispiel jeder der Mehrzahl der elektrischen Verbindungen genau ein Segment der ersten Elektrodenschicht 1 zugeordnet, sodass die erste Elektrodenschicht 1 gerade so viele Segmente aufweist wie elektrische Verbindungen vorhanden sind.

Alternativ dazu kann auch jeweils einer Mehrzahl von elektrischen Verbindungen, etwa zwei, drei oder mehreren benachbarten elektrischen Verbindungen, ein Segment der ersten Elektrodenschicht 1 zugeordnet sein. Das kann bedeuten, dass die Segmente der ersten Elektrodenschicht 1 jeweils über mehrere elektrische Verbindungen elektrisch leitend mit der Stromzuführung 4 verbunden sind.

Im Falle eines Kurzschlusses aufgrund eines Defektes 20 der organischen funktionellen Schicht 2 wird die Leistung als Verlustleistung aufgrund des geringen Widerstandes durch diejenige elektrische Verbindung 56 und das mit der elektrischen Verbindung 56 elektrisch leitende Segment der ersten Elektrodenschicht 1 fließen, das dem Kurzschluss am nächsten ist. Diese elektrische Verbindung 56 wird abschmelzen und einen unendlich hohen Widerstand bilden. Die angrenzende elektrische Verbindung 55 wird aufgrund der geringen Querleitfähigkeit der organischen funktionellen Schicht 2 und des damit verbundenen erhöhten Widerstandes durch einen deutlich niedrigeren Strom belastet als die zuerst abgeschmolzene elektrische Verbindung 56.

Trotzdem kann die Stromdichte an der angrenzenden elektrischen Verbindung immer noch so groß sein, dass ebenfalls die angrenzende elektrische Verbindung 55 abschmilzt. Dabei werden die an den Defekt 20 angrenzenden elektrischen Verbindungen 57, 58 fortgesetzt abschmelzen, bis der Widerstand in der organischen funktionellen Schicht 2 aufgrund der geringen Querleitfähigkeit so groß wird, dass ein Abschmelzen der weiteren elektrischen Verbindungen unterbleibt.

Durch die elektrischen Verbindungen 51, 52, 53, 54, die durch den Defekt 20 bedingten Kurzschluss nicht direkt betroffen sind, kann weiterhin Strom fließen. Da die horizontale Ausdehnung der organischen funktionellen Schicht 2 größer ist als ihre Schichtdicke, ist der elektrische Widerstand durch die organische funktionelle Schicht 2 senkrecht zur Erstreckungsebene der Funktionsschicht 2 geringer als der elektrische Widerstand entlang der Erstreckungsebene, also geringer als der Querleitungswiderstand.

Somit ist es möglich, dass nur sehr wenige elektrische Verbindungen 55, 56, 57, 58 abschmelzen und nur in einem kleinen Bereich des optoelektronischen Bauelementes keine Strahlung emittiert wird, während der übrige Teil des optoelektronischen Bauelements durch die Segmentierung der ersten Elektrodenschicht 1 weiterhin funktionsfähig bleibt.

Die weiteren Merkmale der in den Figuren 1A bis 7 dargestellten Bauelemente können das erfindungsgemäße Bauelement beliebig ergänzen.

## Patentansprüche

1. Optoelektronisches Bauelement mit einer Kurzschlusssicherung, umfassend
- eine erste Elektrodenschicht (1) mit einer Mehrzahl von Segmenten (11, 12), die getrennt voneinander angeordnet sind,
- eine funktionelle Schicht (2) auf der ersten Elektrodenschicht (1), die im Betrieb eine elektromagnetische Strahlung emittiert,
- eine zweite Elektrodenschicht (3) auf der funktionellen Schicht(2),
- eine Stromzuführung (4) und
- eine Mehrzahl von elektrischen Verbindungen (51, 52),
wobei
- zumindest jeweils eine der Mehrzahl der elektrischen Verbindungen (51, 52) zwischen der ersten Stromzuführung (4) und zumindest einem der Mehrzahl der Segmente (11, 12) der ersten Elektrodenschicht (1) zur elektrischen Kontaktierung der ersten Elektrodenschicht (1) angeordnet ist,
- die Stromzuführung (4) einen ersten Querschnitt aufweist und jede der Mehrzahl der elektrischen Verbindungen (51, 52) einen zweiten Querschnitt aufweist,
- der zweite Querschnitt kleiner als der erste Querschnitt ist, und
- die Mehrzahl der elektrischen Verbindungen (51, 52) als Schmelzsicherungen ausgeführt ist,
- das optoelektronische Bauelement ein Substrat (6) umfasst, wobei
- auf einer Hauptoberfläche des Substrats (6) die Stromzuführung (4), die Mehrzahl der elektrischen Verbindungen (51, 52) und die Mehrzahl der Segmente (11, 12) der ersten Elektrodenschicht (1), die funktionelle Schicht (2) und die zweite Elektrodenschicht (3) angeordnet sind, **dadurch gekennzeichnet, dass**
- im Substrat (6) benachbart zu zumindest einer der Mehrzahl der elektrischen Verbindungen (51, 52) ein Hohlraum (7) angeordnet ist,
- der Hohlraum (7) als Reservoir für schmelzendes Material der zumindest einen der Mehrzahl der elektrischen Verbindungen (51, 52) dient.

2. Optoelektronisches Bauelement nach dem vorhergehenden Anspruch, wobei
- der zweite Querschnitt zumindest um einen Faktor 10 im Vergleich zum ersten Querschnitt reduziert ist.

3. Optoelektronisches Bauelement nach einem der vorhergehenden Ansprüche, wobei
- die Stromzuführung (4) und die Mehrzahl der elektrischen Verbindungen (51, 52) einstückig ausgebildet sind oder die Stromzuführung (4) und die Mehrzahl der elektrischen Verbindungen (51, 52) aus verschiedenen Materialien ausgebildet sind.

4. Optoelektronisches Bauelement nach einem der vorhergehenden Ansprüche, wobei
sich die elektrischen Verbindungen (51, 52) durch das Substrat (6) hindurch erstrecken.

5. Optoelektronisches Bauelement nach dem vorhergehenden Anspruch, wobei
- das Substrat (6) eine Mehrzahl von Öffnungen (511, 512) aufweist, wobei in jeder der Mehrzahl der Öffnungen (511, 512) jeweils eine der Mehrzahl der elektrischen Verbindungen (51, 52) angeordnet ist.

6. Optoelektronisches Bauelement nach einem der vorhergehenden Ansprüche, weiterhin umfassend
- eine Isolatorschicht (8), insbesondere eine Isolatorschicht aus einem schmelzbaren und/oder rieselfähigen Material, auf zumindest einer der Mehrzahl der elektrischen Verbindungen (51, 52).

7. Optoelektronisches Bauelement nach Anspruch 6, bei dem die Isolatorschicht aus einem schmelzbaren und/oder rieselfähigen Material besteht.

8. Optoelektronisches Bauelement nach Anspruch 6 oder 7, wobei
- die zumindest eine der Mehrzahl der elektrischen Verbindungen (51, 52) derart ausgeführt ist, dass im Falle eines Kurzschlusses die zumindest eine der Mehrzahl der elektrischen Verbindungen (51, 52) schmilzt und
- die Isolatorschicht (8) geeignet ist, die zumindest eine der Mehrzahl der elektrischen Verbindungen (51, 52) zu isolieren.

9. Optoelektronisches Bauelement nach einem der vorhergehenden Ansprüche, wobei
- die funktionelle Schicht anorganische oder organische Materialien aufweist.

10. Optoelektronisches Bauelement nach einem der vorhergehenden Ansprüche, wobei
- die funktionelle Schicht (2) zumindest zwei Segmente (21, 22) umfasst, die getrennt voneinander angeordnet sind, und
- jeweils ein Segment (21, 22) der funktionellen Schicht (2) auf zumindest einem der Mehrzahl der Segmente (11, 12) der ersten Elektrodenschicht (1) angeordnet ist.

11. Optoelektronisches Bauelement nach einem der Ansprüche 1 bis 8, wobei
- die funktionelle Schicht (2) zusammenhängend über zumindest zweien der Mehrzahl der Segmente (11, 12) der ersten Elektrodenschicht (1) angeordnet ist.

12. Optoelektronisches Bauelement nach einem der vorhergehenden Ansprüche, wobei
- die zumindest zwei der Mehrzahl der Segmente (11, 12) der ersten Elektrodenschicht (1) parallel zueinander verschaltet sind.

13. Optoelektronisches Bauelement nach einem der vorhergehenden Ansprüche, weiterhin umfassend
- zumindest eine Stromaufweitungsschicht (91, 92, 93), die zwischen zumindest einer der Mehrzahl der elektrischen Verbindungen (51, 52, 53) und zumindest einem der Mehrzahl der Segmente (11, 12, 13) der ersten Elektrodenschicht (1) angeordnet ist.

14. Optoelektronisches Bauelement nach einem der vorhergehenden Ansprüche, wobei
- die zweite Elektrodenschicht (3) zumindest zwei Segmente (31, 32) aufweist und
- jeweils eins der zumindest zwei Segmente (31, 32) über zumindest einem der Mehrzahl der Segmente (11, 12) der ersten Elektrodenschicht (1) angeordnet ist.

15. Optoelektronisches Bauelement nach einem der Ansprüche 1 bis 13, wobei
- die zweite Elektrodenschicht (3) zusammenhängend über zumindest zweien der Mehrzahl der Segmente (11, 12) der ersten Elektrodenschicht (1) angeordnet ist.

## Claims

1. An optoelectronic component with short circuit protection, comprising
- a first electrode layer (1) with a plurality of segments (11, 12), which are arranged separately from one another,
- a functional layer (2) on the first electrode layer (1), which emits electromagnetic radiation when in operation,
- a second electrode layer (3) on the functional layer (2),
- a power supply (4) and
- a plurality of electrical connections (51, 52), wherein
- in each case at least one of the plurality of electrical connections (51, 52) is arranged between the first power supply (4) and at least one of the plurality of segments (11, 12) of the first electrode layer (1) for electrical contacting of the first electrode layer (1),
- the power supply (4) has a first cross-section and each of the plurality of electrical connections (51, 52) has a second cross-section,
- the second cross-section is smaller than the first cross-section, and
- the plurality of electrical connections (51, 52) take the form of fuses,
- the optoelectronic component comprises a substrate (6),
wherein
- the power supply (4), the plurality of electrical connections (51, 52) and the plurality of segments (11, 12) of the first electrode layer (1), the functional layer (2) and the second electrode layer (3) are arranged on a major surface of the substrate (6), **characterised in that**
- a cavity (7) is arranged in the substrate (6) adjacent to at least one of the plurality of electrical connections (51, 52),
- the cavity (7) serves as a reservoir for melting material of the at least one of the plurality of electrical connections (51, 52).

2. An optoelectronic component according to the preceding claim, wherein
- the second cross-section is reduced at least by a factor of 10 in comparison with the first cross-section.

3. An optoelectronic component according to one of the preceding claims, wherein
- the power supply (4) and the plurality of electrical connections (51, 52) are of one-piece construction or the power supply (4) and the plurality of electrical connections (51, 52) are made from different materials.

4. An optoelectronic component according to one of the preceding claims, wherein
- the electrical connections (51, 52) extend through the substrate (6).

5. An optoelectronic component according to the preceding claim, wherein
- the substrate (6) comprises a plurality of orifices (511, 512), wherein in each case one of the plurality of electrical connections (51, 52) is arranged in each of the plurality of orifices (511, 512).

6. An optoelectronic component according to one of the preceding claims, further comprising
- an insulator layer (8), in particular an insulator layer made from a meltable and/or flowable material, on at least one of the plurality of electrical connections (51, 52).

7. An optoelectronic component according to claim 6, in which
- the insulator layer (8) consists of a meltable and/or flowable material.

8. An optoelectronic component according to claim 6 or claim 7, wherein
- the at least one of the plurality of electrical connections (51, 52) is embodied such that, in the case of a short circuit, the at least one of the plurality of electrical connections (51, 52) melts and
- the insulator layer (8) is suited to insulating at least one of the plurality of electrical connections (51, 52).

9. An optoelectronic component according to one of the preceding claims, wherein
- the functional layer comprises inorganic or organic materials.

10. An optoelectronic component according to one of the preceding claims, wherein
- the functional layer (2) comprises at least two segments (21, 22), which are arranged separately from one another, and
- in each case one segment (21, 22) of the functional layer (2) is arranged on at least one of the plurality of segments (11, 12) of the first electrode layer (1).

11. An optoelectronic component according to one of claims 1 to 8, wherein
- the functional layer (2) is arranged continuously over at least two of the plurality of segments (11, 12) of the first electrode layer (1).

12. An optoelectronic component according to one of the preceding claims, wherein
- the at least two of the plurality of segments (11, 12) of the first electrode layer (1) are connected parallel to one another.

13. An optoelectronic component according to one of the preceding claims, further comprising
- at least one current spreading layer (91, 92, 93), which is arranged between at least one of the plurality of electrical connections (51, 52, 53) and at least one of the plurality of segments (11, 12, 13) of the first electrode layer (1).

14. An optoelectronic component according to one of the preceding claims, wherein
- the second electrode layer (3) comprises at least two segments (31, 32) and
- in each case one of the at least two segments (31, 32) is arranged over at least one of the plurality of segments (11, 12) of the first electrode layer (1).

15. An optoelectronic component according to one of claims 1 to 13, wherein
- the second electrode layer (3) is arranged continuously over at least two of the plurality of segments (11, 12) of the first electrode layer (1).

## Revendications

1. Composant optoélectronique doté d'un fusible court-circuit, comprenant
- une première couche d'électrode (1) munie d'une pluralité de segments (11, 12) disposés séparément les uns des autres,
- une couche fonctionnelle (2) sur la première couche d'électrode (1), laquelle émet un rayonnement électromagnétique en fonctionnement,
- une deuxième couche d'électrode (3) sur la couche fonctionnelle (2),
- une alimentation en courant (4) et
- une pluralité de liaisons électriques (51, 52),
- au moins respectivement une de la pluralité des liaisons électriques (51, 52) étant disposée entre la première alimentation en courant (4) et au moins un de la pluralité des segments (11, 12) de la première couche d'électrode (1) pour la connexion électrique de la première couche d'électrode (1),
- l'alimentation en courant (4) présentant une première section transversale et chacune de la pluralité des liaisons électriques (51, 52) présentant une deuxième section transversale,
- la deuxième section transversale étant inférieure à la première section transversale, et
- la pluralité de liaisons électriques (51, 52) étant réalisée en tant que fusibles,
- le composant optoélectronique comprenant un substrat (6),
- l'alimentation en courant (4), la pluralité des liaisons électriques (51, 52), et la pluralité des segments (11, 12) de la première couche d'électrode (1), la couche fonctionnelle (2) et la deuxième couche d'électrode (3) étant disposées sur une surface principale du substrat (6), **caractérisé en ce qu'**
- une cavité (7) est disposée dans le substrat (6) de manière avoisinante à au moins une de la pluralité des liaisons électriques (51, 52),
- la cavité (7) servant de réservoir pour la matière en fusion de l'au moins une de la pluralité des liaisons électriques (51, 52).

2. Composant optoélectronique selon la revendication précédente,
- la deuxième section transversale étant réduite au moins d'un facteur 10 en comparaison avec la première section transversale.

3. Composant optoélectronique selon l'une quelconque des revendications précédentes,
- l'alimentation en courant (4) et la pluralité des liaisons électriques (51, 52) étant réalisées d'une seule pièce ou l'alimentation en courant (4) et la pluralité des liaisons électriques (51, 52) étant réalisées dans différentes matières.

4. Composant optoélectronique selon l'une quelconque des revendications précédentes,
- les liaisons électriques (51, 52) s'étendant à travers le substrat (6).

5. Composant optoélectronique selon l'une quelconque des revendications précédentes,
- le substrat (6) présentant une pluralité d'orifices (511, 512), une de la pluralité des liaisons électriques (51, 52) étant respectivement disposée dans chacun de la pluralité des orifices (511, 512).

6. Composant optoélectronique selon l'une quelconque des revendications précédentes, comprenant en outre
- une couche isolante (8), notamment une couche isolante constituée d'une matière fusible et/ou coulable, sur au moins une de la pluralité des liaisons électriques (51, 52).

7. Composant optoélectronique selon la revendication 6, dans lequel la couche isolante (8) est constituée d'une matière fusible et/ou coulable.

8. Composant optoélectronique selon la revendication 6 ou 7,
- l'au moins une de la pluralité des liaisons électriques (51, 52) étant réalisée de manière à ce qu'en cas d'un court-circuit l'au moins une de la pluralité des liaisons électriques (51, 52) fonde et
- la couche isolante (8) étant apte à isoler l'au moins une de la pluralité des liaisons électriques (51, 52).

9. Composant optoélectronique selon l'une quelconque des revendications précédentes,
- la couche fonctionnelle présentant des matières anorganiques ou organiques.

10. Composant optoélectronique selon l'une quelconque des revendications précédentes,
- la couche fonctionnelle (2) comprenant au moins deux segments (21, 22) disposés séparément les uns des autres, et
- respectivement un segment (21, 22) de la couche fonctionnelle (2) étant disposé sur au moins un de la pluralité des segments (11, 12) de la première couche d'électrode (1).

11. Composant optoélectronique selon l'une quelconque des revendications 1 à 8,
- la couche fonctionnelle (2) étant disposée de manière continue sur au moins deux de la pluralité des segments (11, 12) de la première couche d'électrode (1).

12. Composant optoélectronique selon l'une quelconque des revendications précédentes,
- les au moins deux de la pluralité des segments (11, 12) de la première couche d'électrode (1) étant connectés parallèlement l'un à l'autre.

13. Composant optoélectronique selon l'une quelconque des revendications précédentes, comprenant en outre
- au moins une couche d'extension de courant (91, 92, 93) qui est disposée entre au moins une de la pluralité des liaisons électriques (51, 52, 53) et au moins un de la pluralité des segments (11, 12, 13) de la première couche d'électrode (1).

14. Composant optoélectronique selon l'une quelconque des revendications précédentes,
- la deuxième couche d'électrode (3) présentant au moins deux segments (31, 32) et
- respectivement un des au moins deux segments (31, 32) étant disposé sur au moins un de la pluralité des segments (11, 12) de la première couche d'électrode (1).

15. Composant optoélectronique selon l'une quelconque des revendications 1 à 13,
- la deuxième couche d'électrode (3) étant disposée de manière continue sur au moins deux de la pluralité des segments (11, 12) de la première couche d'électrode (1).
